# FASCICULE DE BREVET EUROPEEN

(11) **EP 0 850 266 B1**
(45) Date de publication et mention de la délivrance du brevet: **05.06.2002**
(21) Numéro de dépôt: 96931762.7
(22) Date de dépôt: 02.09.1996
(51) Int. Cl.: C08J 7/06, C23C 16/44, E04F 15/00

(54) **PROCEDE D'OBTENTION D'UN REVETEMENT DE SOL ET PRODUIT OBTENU**
VERFAHREN ZUR HERSTELLUNG EINES BODENBELAGES UND SO HERGESTELLTES PRODUKT
METHOD FOR OBTAINING A FLOOR COVERING AND PRODUCT THUS OBTAINED

(30) Priorité: 15.09.1995 EP 95870103
(43) Date de publication de la demande: 01.07.1998
(73) Titulaire: Tarkett Sommer S.A., 92748 Nanterre Cedex (FR)
(72) Inventeur: BACLEZ, Emmanuelle, F-59000 Lille (FR); MUTEL, Brigitte, F-59115 Leers (FR); DESSAUX, Odile, F-59800 Lille (FR); GOUDMAND, Pierre, F-59800 Lille (FR)
(74) Mandataire: Van Malderen, Joelle
(86) Numéro de dépôt international: EP9603859
(87) Numéro de publication internationale: WO9710287

(56) Documents cités:
- EP-A- 0 590 467
- WO-A-94/18355
- WO-A-95/19456
- WO-A-95/23652
- DD-A- 107 312
- US-A- 5 188 876

## Description

### Objet de l'invention.

La présente invention se rapporte à un procédé d'obtention d'un revêtement de sol comprenant au moins un substrat constitué d'une matière polymérique.

La présente invention se rapporte également au revêtement de sol obtenu selon ce procédé.

### Arrière-plan technologigue.

Depuis longtemps, on connaît les revêtements de sol de type vinylique. Leur composition est basée essentiellement sur des homo- ou copolymères de chlorure de vinyle appelés couramment PVC.

En outre, on observe depuis peu l'apparition sur le marché de produits destinés à des revêtements de sol qui sont essentiellement réalisés à base de résine acrylique ou d'homo- ou copolymères d'oléfine en vue de remplacer ces revêtements de type PVC, ceci notamment pour des raisons liées à la protection de l'environnement.

Ces revêtements polymériques destinés au recouvrement du sol sont appelés par l'homme du métier des revêtements polymériques "résilients", par opposition aux revêtements tels que la céramique et le bois qui sont non résilients.

Parmi les revêtements polymériques, on retrouve les revêtements polymériques thermoplastiques mentionnés ci-dessus, mais également certains revêtements polymériques thermodurcissables comprenant des résines mélamines utilisées pour réaliser des revêtements de sol.

Par essence, ces revêtements de sol, quelle que soit leur nature, sont soumis à un trafic important et subissent de ce fait une détérioration plus ou moins rapide par usure.

En réalité, cette détérioration est essentiellement due à la rayabilité du revêtement par le frottement de particules dures.

De ce fait, on a proposé divers procédés pour améliorer la résistance des revêtements de sol en augmentant la dureté de leur surface essentiellement par dépôt d'une couche de protection.

La plupart des couches de protection appelées plus généralement en anglais "top coats" actuellement utilisées sont du type organique, et en particulier sont à base de polyuréthanes, contenant généralement des isocyanates aliphatiques.

L'application de tels recouvrements peut se faire à partir de solutions en phase organique de systèmes à un ou deux composant(s), de dispersions aqueuses ou de systèmes réactifs à 100% d'extrait sec.

On peut mentionner que les systèmes en solution sont réticulés par des polyéthers ou des polyesters hydroxylés dont il existe de nombreux types. On utilise également des polymères acryliques hydroxylés comme réticulant de diisocyanates. La réticulation se fait au four et requiert un catalyseur.

Les systèmes polyuréthanes en phase aqueuse sont quant à eux réticulés par des résines mélamines ou des aziridines au four.

Les systèmes sans solvant sont destinés au séchage sous rayonnement UV. Ce sont des polyuréthanes obtenus à partir de diisocyanates, de polyesters ou polyéthers hydroxylés et de monomères acryliques hydroxylés. Ils peuvent être dilués avec des monomères polyacrylés réactifs pour régler la viscosité d'application. Le séchage est extrêmement rapide mais requiert l'addition de photoinitiateurs.

On a relevé l'usage d'autres systèmes tels que :
- organoalkoxysilane ou alkylsilicate hydrolysé + élastomères polyuréthanes,
- résine alkyde + polyméthoxybutoxytriméthylsil-oxysilane + résine mélamine butoxylée,
- résine mélamine éthoxylée + résine époxy + copolymère styrène-alcool allylique ... .

Il convient de noter que ces "top coats" sont, dans la littérature, toujours appliqués à des revêtements de sol de type vinylique, c'est-à-dire à base essentiellement de PVC.

Par contre, dans le cas de revêtements de sol à base d'autres polymères, comme par exemple les copolymères EVA (éthylène-vinylacétate), aucune mention précise de couche de protection n'a été faite dans la littérature.

Néanmoins, les diverses techniques proposées se heurtent à certaines difficultés, dont les principales sont la rayabilité et la perte d'aspect, notamment le degré de brillance et de transparence, défauts liés au trafic. De plus, l'adhérence de la couche de protection sur le substrat, qui est, dans le cas d'un revêtement de sol, un substrat polymérique résilient, et la stabilité mécanique entre le dépôt du matériau organique constituant la couche de protection ou d'usure et le substrat lui-même sont souvent insuffisantes.

### Etat de la technique

Les documents US-A-5188876 et US-A-5077112 décrivent des revêtements de surface, et en particulier des revêtements de sol, comprenant plusieurs couches, dont au moins une couche d'usure réalisée en un matériau dur inorganique déposée sur un support par des techniques travaillant dans des conditions de pressions réduites.

Parmi ces techniques sont cités le bombardement ionique, la polymérisation plasma, l'implantation ionique et le plasma ionique.

Le support peut être choisi parmi les matériaux suivants : métal, film ou feuille plastique, caoutchouc ou support comprenant un minéral. Parmi les matériaux plastiques sont cités les matériaux thermoplastiques et les matériaux thermodurcissables. A titre d'exemple, on cite le polyéthylène téréphtalate ainsi que les polyesters éventuellement renforcés. Le PVC est également cité.

Pour ce qui concerne la couche d'usure, celle-ci est réalisée à partir d'un matériau dur inorganique comprenant des métaux, des oxydes ou des nitrures de métaux et présentant une dureté d'au moins 5 mohs. A titre d'exemples sont cités plus particulièrement les oxydes et nitrures de silicium.

L'épaisseur de cette couche est comprise entre 1 et 25 microns.

Les techniques citées du type plasma ionique ou thermique risquent de provoquer un échauffement important du support et une détérioration de celui-ci. De plus, il est difficile de réaliser des conditions opératoires satisfaisantes dans des volumes importants, sauf en multipliant les sources.

Dans ces deux documents américains, on mentionne également que la couche superficielle est polycristalline.

Le document WO-A-95/19456 décrit un procédé général pour déposer une couche de métal ou de semi-métal ou de leur oxyde sur un substrat par la technique du plasma froid différé d'azote, le substrat pouvant être un métal, un alliage, une céramique, un polymère, des matériaux composites ou encore du verre. A titre d'exemple, un substrat en polypropylène est cité.

En vue de réaliser ce procédé, un dérivé alkyle volatile dudit métal ou semi-métal est introduit dans une enceinte fermée, de manière à décomposer ledit alkyle et à réaliser le dépôt sur le substrat de la couche de métal, de semi-métal ou de leur oxyde.

Le document WO-A-95/23652 décrit un procédé de dépôt sur un substrat par un faisceau ionique d'un revêtement résistant à l'abrasion comprenant une ou plusieurs couches.

Le matériau destiné à produire le recouvrement doit être optiquement transparent et être constitué à partir de carbure de silicium, de nitrure de silicium, d'oxyde de silicium, d'oxynitrure de silicium, d'oxycarbure de silicium, de carbonitrure de silicium ou d'oxycarbonitrure de silicium.

Le substrat sur lequel le recouvrement est déposé peut être une matière plastique, un métal, du verre ou de la céramique, et est destiné à des applications particulières telles que des lentilles ophtalmiques, des lentilles plastiques, des fenêtres de scanner de barre-codes ou d'autres éléments pouvant se détériorer rapidement. Il convient de noter que le substrat n'est pas un matériau résilient.

Le document DD-A-107312 décrit un procédé de recouvrement de surface plastique telle que le PVC et le polyéthylène par une couche "anti-glissante", réalisée à partir d'un matériau céramique ou métallique au moyen d'un dispositif de pulvérisation thermique tel qu'un pistolet plasma.

Le document EP-A-0590467 décrit un procédé de dépôt d'une couche à base d'oxyde de silicium sur des matériaux synthétiques tels que le polyméthylmétacrylate ou le polycarbonate par un traitement plasma à l'aide d'un composé organoxilane ou organoxiloxane sous forme gazeuse.

Le document WO-A-94/18355 décrit un procédé pour appliquer une couche mince sur un substrat métallique inorganique ou organique à l'aide d'un plasma froid différé d'azote en vue de la réalisation de dispositifs électroniques ou micro-électroniques. Plus particulièrement, ce procédé est destiné à la formation de couches minces diélectriques dans lesquelles des composés organométalliques interviennent.

### Buts de l'invention.

La présente invention vise à proposer un procédé d'obtention d'un revêtement de sol qui est constitué d'un substrat polymérique résilient, c'est-à-dire qui se déforme sous l'impact, et qui possède une couche de protection transparente qui présente des caractéristiques de résistance à l'usure améliorées par rapport à celles des revêtements de sol proposés par divers procédés de l'état de la technique.

En particulier, la présente invention vise à proposer un procédé d'obtention qui permette d'obtenir une bonne adhésion du recouvrement servant de couche de protection sur le substrat sans devoir avoir recours à un procédé "multicouche".

La présente invention vise également à proposer un procédé qui soit une "technique propre", et dont la mise en oeuvre peut se réaliser à température ambiante et sans que le substrat ne soit chauffé à des températures risquant de l'abîmer.

En outre, la présente invention vise à proposer un procédé qui permet de traiter des surfaces importantes, et donc qui permette une mise en oeuvre du procédé à une échelle industrielle, dans des conditions techniques, notamment de vide et de température, acceptables.

Le problème technique particulier auquel on se heurte lorsque l'on désire déposer une couche de protection dure sur un support souple en matériau polymérique du type de ceux utilisés comme revêtements de sol est le fait que d'une part, il convient d'éviter d'abîmer le substrat lors du traitement, et que d'autre part, la couche de protection dure doit également ne pas être trop rigide. En fait, cette couche de protection doit être suffisamment souple ou élastique pour que le produit de revêtement de sol puisse être enroulé, posé et utilisé de la manière classique pour les revêtements de sol actuellement sur le marché.

Une contrainte supplémentaire à laquelle font d'ailleurs allusion les documents US-A-5077112 et US-A-5188876 est le fait que la couche de protection doit présenter de bonnes caractéristiques d'adhérence au substrat.

La probabilité d'obtenir une couche de protection qui soit à la fois dure et adhérente au substrat résilient est donc très faible. De plus, les conditions opératoiree doivent être telles que la nature du support ne soit pas altérée au cours du traitement.

### Principaux éléments caractéristiques de la présente invention

La présente invention vise à proposer un procédé d'obtention d'un revêtement de sol comprenant au moins un substrat polymérique résilient, c'est-à-dire déformable sous l'impact, et une couche de protection constituée d'au moins un nitrure inorganique amorphe, dans lequel le dépôt de ladite couche de protection sur ledit substrat polymérique résilient comprend les étapes suivantes :
- on place ledit substrat dans une enceinte,
- on forme un plasma froid différé à base d'azote que l'on injecte dans ladite enceinte,
- on injecte dans ladite enceinte un composé précurseur volatil, ledit plasma froid différé à base d'azote induisant alors une réaction de décomposition dudit composé précurseur volatile,
de façon à obtenir une couche de protection présentant une dureté Vickers supérieure à 1 GPa et un module d'élasticité (module de Young) inférieur à 80 GPa.

De préférence, on effectue le dépôt de la couche de protection sur une épaisseur inférieure à 10 µm, et plus particulièrement comprise entre 1 et 5 µm.

Il est surprenant que le revêtement de sol qui comprend d'une part un substrat polymérique résilient et d'autre part une couche de protection d'une substance inorganique dure soit satisfaisant pour ce qui concerne d'une part les propriétés propres aux revêtements de sol telles que l'enfoncement, une bonne réponse à la déformabilité et aux sollicitations mécaniques liées au trafic, et d'autre part les propriétés propres à la couche de protection, telles que la résistance à l'usure et à la rayabilité. On a donc réalisé un compromis entre des propriétés qui pouvaient sembler en principe contradictoires.

On observe également de manière surprenante que les propriétés d'adhérence de la couche de protection dure sur le substrat résilient sont tout à fait satisfaisantes.

De préférence, le plasma froid différé utilisé sera un plasma à base d'azote induit par décharge de type micro-ondes ou de type radiofréquence.

La fréquence utilisée pour créer le plasma est préférentiellement de 2450 MHz ou 13,56 MHz.

Selon une forme d'exécution, on préfère travailler dans la zone de post-décharge de plasma froid différé, en particulier dans la zone de post-décharge "lointaine", c'est-à-dire dans la zone de post-décharge exempte d'espèces ioniques. La zone de post-décharge lointaine à base d'azote offre plusieurs avantages, tels que la possibilité de travailler à grand volume, ce qui est particulièrement important dans le cas d'un traitement d'un revêtement de sol, et la possibilité de travailler à des températures proches de la température ambiante, à savoir une température ne dépassant pas 325 °K, en évitant ainsi toute détérioration du substrat polymérique.

Le revêtement de sol obtenu comprend au moins un substrat polymérique résilient constitué à partir de PVC, de résines acryliques ou d'homo- ou copolymère d'oléfine mais également à partir de résines à base de mélamine.

La couche de protection que l'on désire obtenir en vue de recouvrir le substrat polymérique résilient est constituée d'un élément inorganique, ayant une dureté supérieure à celle de la matière constituant le substrat polymérique, et de préférence comprise entre 1 et 10 GPa (mesuré selon la méthode Vickers), alors que les substrats polymériques usuels présentent une dureté comprise entre 10 et 100 MPa.

La couche de protection est de préférence constituée sous forme d'un film transparent d'un élément inorganique dont le module d'élasticité est compris entre 20 et 50 GPa.

Parmi ces différents éléments, le nitrure de silicium, qui est connu pour sa dureté élevée, est un choix particulièrement avantageux. En utilisant la technique de plasma froid différé, on obtiendra de manière surprenante un effet combiné de caractéristiques de dureté et d'élasticité de la couche de protection.

Selon la nature de la couche de protection obtenue, on utilise un précurseur adéquat. En particulier dans le cas de la réalisation d'une couche de protection se présentant sous forme d'un nitrure de silicium, qui constitue le choix le plus adéquat dans l'état actuel des connaissances pour atteindre les valeurs paramétriques indiquées, on utilise un précurseur de silicium qui est de préférence un silane, tel que SiH₄, ou un autre dérivé du silicium, notamment SiCl₄, SiF₄, SiH₂Cl₂, SiHCl₃, Si₂H₆, Si₃H₈, CH₃-CH₂-SiH₂Cl, CH₃-CH₂-SiHCl₂, [N(CH₃)₂]₃SiH, [N(CH₃)₂]₄Si, etc.

Le précurseur est introduit dans la zone de post-décharge lointaine, de préférence colinéairement au gaz plasmagène.

Selon une forme d'exécution préférée de l'invention, on procède également à un pré-traitement par plasma froid différé en vue d'augmenter l'énergie de surface des polymères constituant le substrat résilient, et donc de favoriser leur aptitude à l'adhésion sans altérer leurs propriétés, et ceci de préférence également en zone de post-décharge lointaine.

Selon une autre forme d'exécution préférée, on effectue un post-traitement par plasma en vue d'éliminer les traces résiduelles de précurseur. Ceci se réalise de préférence par un plasma froid différé à base d'azote postérieurement au dépôt de la couche de protection.

Habituellement, les pressions de travail sont comprises entre 1 et 20 hPa et les températures sont proches de la température ambiante. Ceci permet de transposer la technique pour une mise en oeuvre industrielle, étant donné notamment des conditions de vide moins exigeantes.

Le dispositif pour la mise en oeuvre du procédé selon la présente invention comporte au moins une enceinte réactionnelle étanche, raccordée de manière étanche à au moins deux voies d'injection, dont l'une au moins est munie d'un moyen pour former un plasma froid différé et dont l'autre sert à amener dans l'enceinte réactionnelle le précurseur sous forme volatile. En outre, l'enceinte est munie d'un orifice d'évacuation raccordé à un système de pompage en continu.

### Brève description des figures.

- La figure 1: représente une vue schématique du dispositif destiné à la mise en oeuvre du procédé tel que décrit dans la variante d'exécution ci-dessus.
- Les figures 2, 3, 4 et 5: représentent des spectres infra-rouges pour différentes variétés de nitrure de silicium.
- La figure 6: représente un spectre infra-rouge pour une couche de protection à base de nitrure de silicium obtenue selon le procédé de la présente invention.
- Les figures 7, 8 et 9: représentent des spectres Raman pour différentes variétés de nitrure de silicium.
- La figure 10: représente un spectre Raman pour une couche de protection à base de nitrure de silicium obtenue selon la présente invention.
- Les figures 11 et 12: représentent des vues photographiques de la couche de protection constituée de nitrure de silicium déposé sur un substrat PVC avant et après avoir été soumise au test Taber.
- Les figures 13 et 14: représentent des vues photographiques d'un substrat PVC non revêtu d'une couche de protection avant et après avoir été soumis au test Taber.
- La figure 15: représente une vue photographique de la couche de protection déposée sur un substrat PVC après avoir été soumise à l'essai "Scratch Test".

### Description détaillée d'une forme d'exécution préférée de la présente invention.

La présente invention sera décrite plus précisément en se référant à un dispositif dans le cadre de la mise en oeuvre d'un procédé utilisant un plasma froid différé à base d'azote et dans lequel le composé volatil servant de précurseur est le silane, en vue d'obtenir par l'action du plasma une dissociation du précurseur permettant de créer un dépôt d'un fin film constitué notamment de nitrure de silicium sur le substrat polymérique du revêtement de sol.

Un tel film peut être réalisé sur tout substrat polymérique résilient, et en particulier sur un substrat PVC.

D'autre part, en utilisant la même technique, on peut espérer, en choisissant de manière précise le précurseur adéquat, réaliser des dépôts de fins films de substances inorganiques dures telles que celles représentées au tableau 1, dans lequel ces substances sont classées par ordre de dureté croissante.

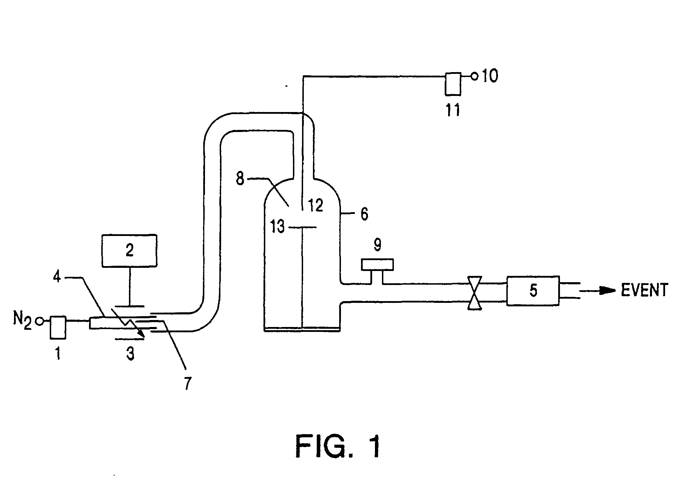

La figure 1 représente le dispositif expérimental utilisé pour créer un plasma froid différé à base d'azote (PFDA). Un flux d'azote moléculaire, régulé par un débitmètre massique 1, est excité au moyen d'une décharge électrique sans électrode par l'intermédiaire d'un générateur micro-ondes 2 relié à une cavité résonnante 3. Dans le présent cas, on utilise un générateur d'une fréquence de 2450 MHz. La décharge est produite dans un tube 4 de 22 mm de diamètre intérieur. Par un pompage continu, assuré par une pompe primaire 5, le plasma est transféré dans la chambre de réaction 6 située à environ 1,10 m de la décharge. Le plasma de décharge 7 correspondant à la zone d'action du champ électrique est caractérisé par une concentration importante d'espèces ioniques. Le plasma froid différé à base d'azote (PFDA) obtenu dans la chambre de réaction 8 est caractérisé par des espèces actives non ioniques correspondant à une zone de post-décharge lointaine. Un capteur de pression ou jauge de Pirani 9 permet de mesurer le vide initial (de l'ordre de 10⁻² hPa) ainsi que la pression de travail, qui est comprise entre 1 et 20 hPa, et de préférence entre 1 et 5 hPa, en sortie du réacteur.

Le gaz réactif utilisé comme précurseur 10 dans la forme d'exécution décrite est un composé volatil du silane. Ce gaz est introduit à l'aide d'un débitmètre massique de régulation de gaz et d'un injecteur tubulaire 12, colinéairement au flux de gaz plasmagène dans la zone de post-décharge lointaine 8. On peut envisager d'utiliser un injecteur comportant un ou plusieurs orifices d'injection permettant de réaliser un dépôt uniforme et homogène sur des substrats de grandes dimensions.

Les échantillons sur lesquels s'effectue le dépôt sont placés sur un porte-échantillon 13 dont la distance par rapport à l'injecteur est variable. En jouant sur la rotation et/ou sur le défilement du porte-échantillon, on peut également réaliser un dépôt uniforme sur ledit échantillon.

Selon une forme d'exécution préférée, le processus de dépôt s'effectue en trois étapes :
- la première étape consiste à traiter des échantillons d'un revêtement de sol comprenant un substrat polymérique résilient par un plasma froid différé d'azote (PFDA) en vue d'augmenter les propriétés adhésives de surface du polymère par greffage de nouvelles fonctions chimiques, cette première étape s'effectuant en zone de post-décharge lointaine; cette première étape s'effectue en zone de post-décharge lointaine pendant quelques minutes;
- la seconde étape consiste en la réalisation du dépôt qui est effectuée directement après l'étape de pré-traitement et sans remise à l'air, par l'injection du gaz réactif précurseur (de préférence le silane) dans le plasma froid différé à base d'azote, toujours en zone de post-décharge lointaine. La zone de dépôt peut être aisément modifiée en faisant varier les rapports de pression partielle des gaz plasmagène et précurseur;
- la dernière étape, qui est l'étape d'après dépôt, consiste à exposer à nouveau le substrat à un gaz plasma froid différé d'azote durant quelques minutes en vue d'éliminer toute trace du précurseur dans l'enceinte réactionnelle.

En réalisant le procédé tel que décrit précédemment, et plus particulièrement en réalisant les différentes étapes reprises ci-dessus, on obtiendra un dépôt d'une couche d'un élément inorganique amorphe présentant de manière surprenante une dureté relativement élevée, c'est-à-dire supérieure à 1 GPa pour un module d'élasticité inférieur à 80 GPa.

C'est probablement la nature particulière de la technique de dépôt de l'élément inorganique qui confère cette combinaison surprenante de caractéristiques opposées comme la dureté et l'élasticité.

Dans le cas particulier d'une couche de protection en nitrure de silicium, la distinction entre un nitrure de silicium amorphe et un nitrure de silicium cristallin peut s'effectuer soit à l'aide de l'analyse de spectre infra-rouge, soit à l'aide de l'analyse de spectre Raman.

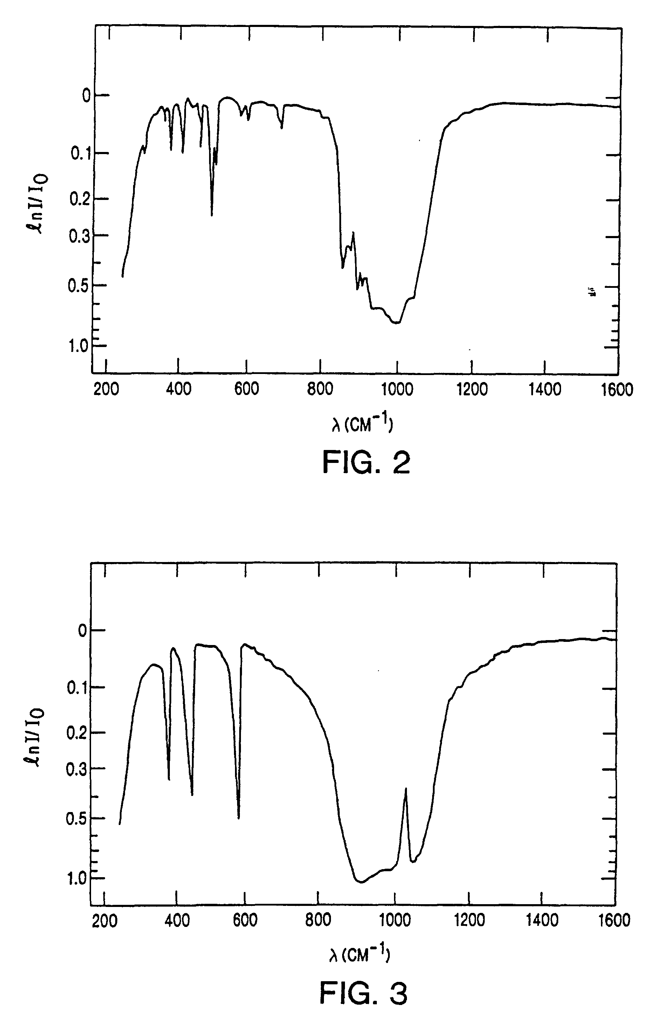

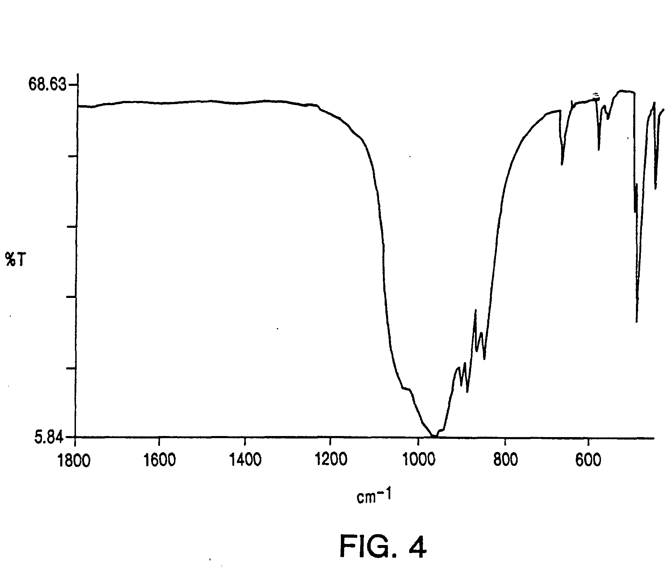

Les figures 2, 3 et 4 représentent des spectres infra-rouges effectués pour des poudres de nitrure de silicium cristallin, présentant respectivement la forme cristalline α-Si₃N₄ à la figure 2, β-Si₃N₄ à la figure 3 et un mélange des deux formes cristallines à la figure 4. On observe dans ces différents cas, de nombreuses raies dont les principales bandes d'absorption sont positionnées à 950 et 495 cm⁻¹ et qui sont dues respectivement au mode d'élongation anti-symétrique et symétrique des groupements Si-N-Si.

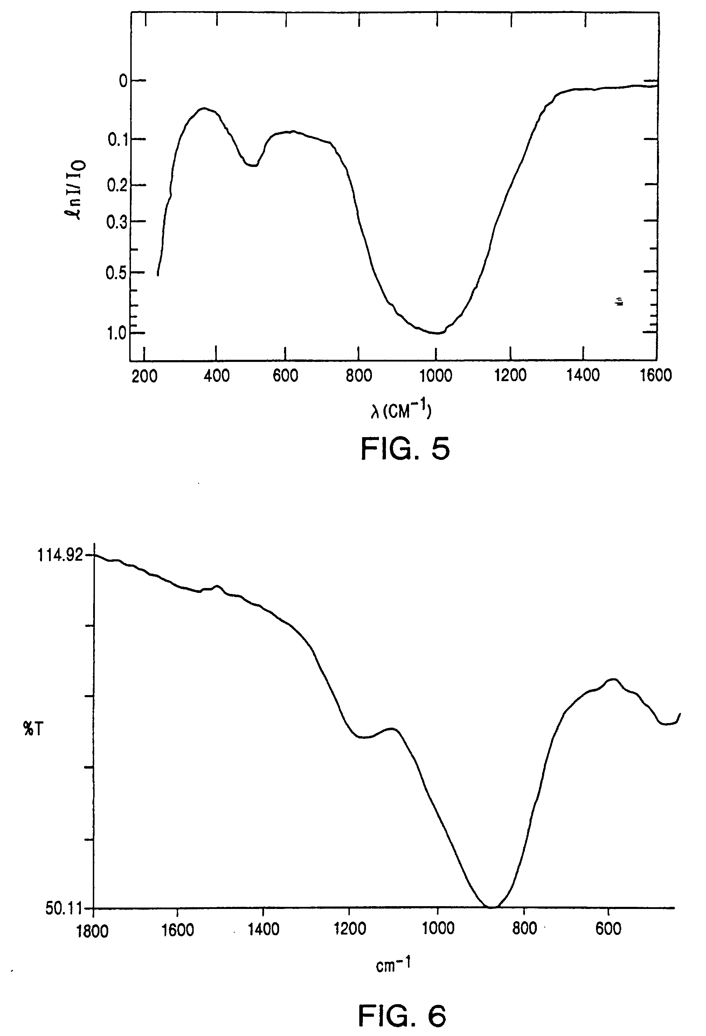

A titre de comparaison, on a également représenté le spectre d'une poudre de nitrure de silicium amorphe à la figure 5.

Les figures 2, 3 et 5 ont été retirées des travaux de N. Wada et al. (N. Wada, S.A. Solin; J. Wong et S. Prochazka, J. Non-Crystalline Solids 43, p. 7 (1981)), tandis que la figure 4 a été réalisée par les Inventeurs au Laboratoire Lefemo-Lille.

Dans le cas d'une couche de protection se présentant sous la forme de nitrure de silicium amorphe obtenue en réalisant le procédé selon la présente invention, on observera à la figure 6 que les structures fines caractéristiques de l'ordre à moyenne distance observées pour les phases cristallines α et β disparaissent pour donner des bandes plus larges. Ceci est dû à l'augmentation du désordre global dans le réseau amorphe. En particulier, on distingue dans ce spectre une bande dissymétrique intense centrée autour du pic 870 cm⁻¹.

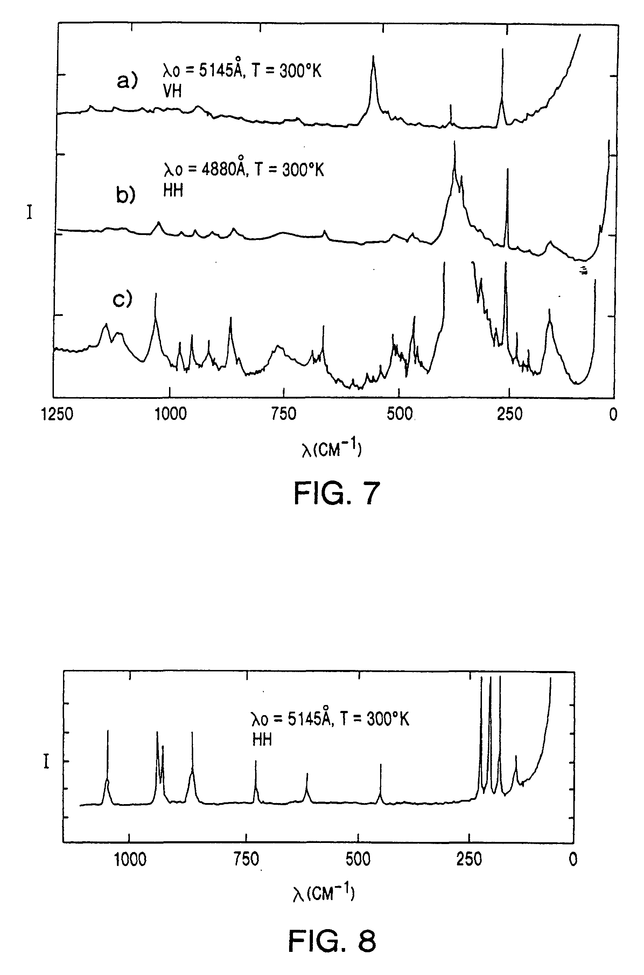

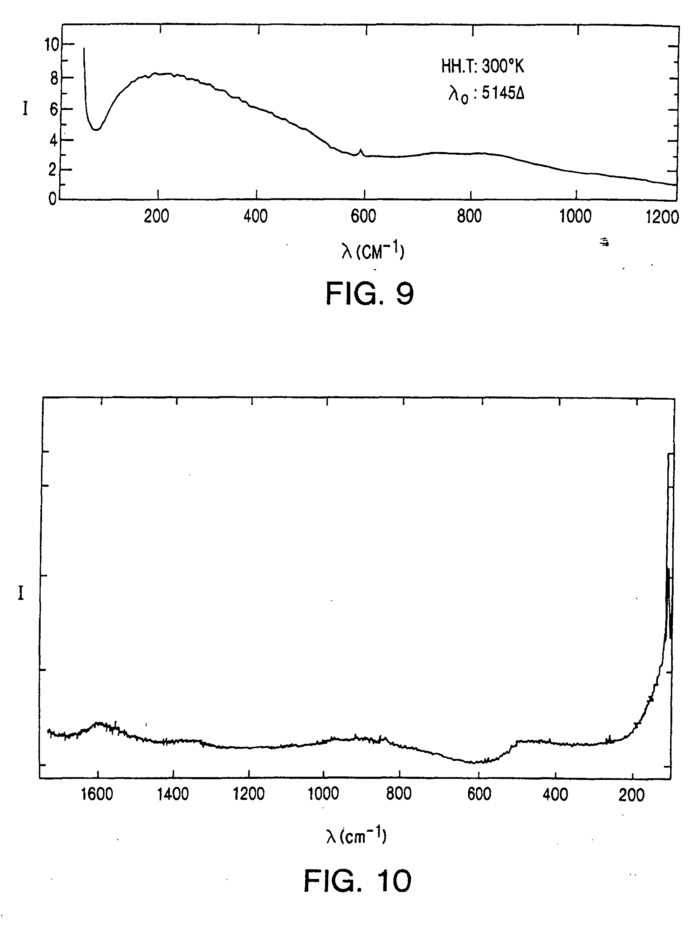

Les mêmes observations peuvent être faites sur les spectres Raman représentés aux figures 7 à 10. Dans le cas d'un nitrure de silicium cristallin présentant la forme α ou β tel que représenté aux figures 7 et 8, on observe de nombreuses raies. A nouveau, à titre de comparaison, on a représenté à la figure 9 un spectre Raman d'une poudre de nitrure de silicium amorphe. Ces figures ont à nouveau été tirées des travaux de N. Wada et al.

Dans le cas d'une couche de protection amorphe obtenue en appliquant le procédé selon la présente invention et représentée plus particulièrement à la figure 10, on observe une forme plus continue du spectre due au manque d'ordre dans le réseau.

### Exemples

### Exemple 1

### a. Protocole expérimental

Un échantillon de revêtement de sol constitué par un substrat PVC est placé dans une chambre réactionnelle à environ 15 mm de l'injecteur. Après l'obtention d'un vide initial de 1,8 10⁻² hPa, l'azote plasmagène est introduit avec un débit de 2,20 Nl/min, sous une pression de 6,2 hPa.

Le PFDA est créé à partir d'une décharge micro-ondes à 2450 MHz avec une puissance de 400 W.

Après 5 minutes de pré-traitement, la pression d'azote est amenée à 1,3 hPa, et le précurseur du silicium (silane dilué à 5% dans l'azote) est injecté dans le PFDA avec un débit de 15 Ncm³/min. La durée d'injection du précurseur est fonction de l'épaisseur du dépôt souhaitée. Des exemples sont repris dans le tableau 3.

Après la phase de dépôt, un plasma froid différé d'azote est également effectué pendant 3 minutes à la pression de 1,3 hPa.

### b. Caractéristiques du film déposé

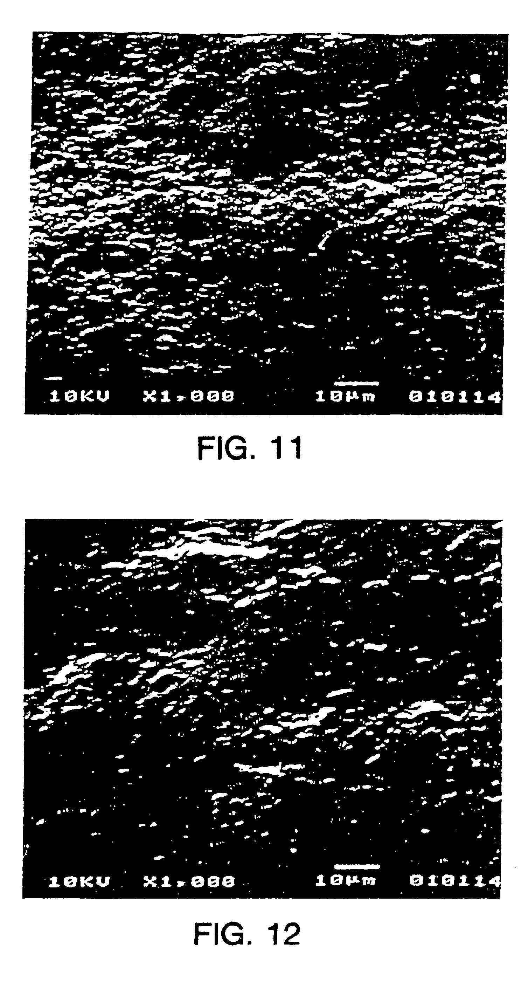

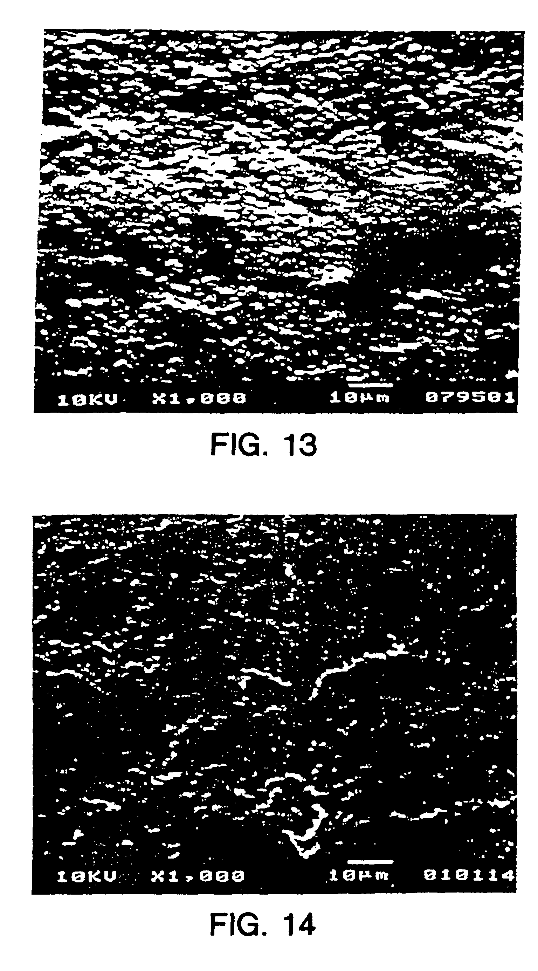

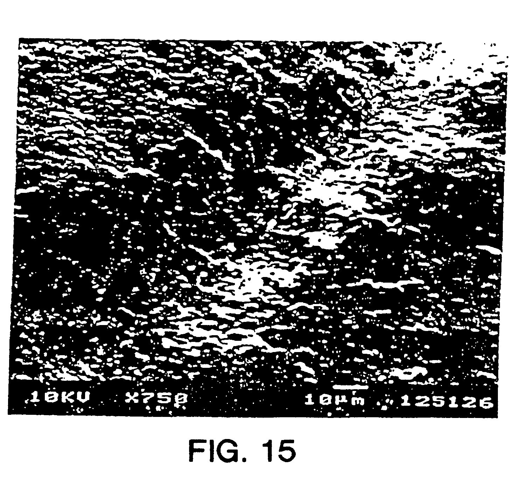

- chimiques : le film déposé est principalement constitué de nitrure de silicium hydrogéné, dont les bandes principales du spectre d'absorption IR analysé par transmission du dépôt réalisé sur silicium sont :
   SiN (autour de 870 capteur magnétique⁻¹)
   Si-NH (3350; 1170 capteur magnétique⁻¹)
- physiques : le film obtenu est transparent, dur, élastique, adhérent et résistant à l'abrasion
   * le test du poinçonnement statique révèle une bonne adhérence du film (pas de décohésion entre le film déposé et le revêtement de sol) malgré une déformation de 70 µm pour un film d'une épaisseur moyenne de 4 µm.
   * la résistance à l'abrasion a été mesurée au test Taber. Il convient de noter qu'après 2000 cycles de Taber (ASTM D-1044) en utilisant les meules CS-10F pour une charge de 500 g, on observe que la couche de protection d'une épaisseur de environ 4 µm ne présente aucune modification de surface et aucun décollement avec le substrat PVC (voir figures 11 et 12). On a réalisé ce même test d'abrasion sur un substrat en PVC non recouvert d'une couche de protection, et on observe dans ce cas que le substrat est déjà abîmé après 100 tours et totalement détérioré au bout de 2000 tours (voir figures 13 et 14).
   * le caractère élastique de la couche de protection peut être mesuré en effectuant un essai appelé "Scratch Test" à l'aide d'un indenteur Berkovitch présentant une profondeur imposée de 15 µm qui réalise une rayure d'une longueur de 2 mm. Dans ce cas, la couche de protection d'une épaisseur de environ 4 µm ne présente à nouveau aucune modification de surface et aucun décollement avec le substrat PVC alors que celui-ci reste déformé (voir également figure 15). En effet, la profondeur de la rayure (après le test) est encore de 7 µm.
   * la dureté a été mesurée selon la méthode Vickers et vaut 9 GPa tandis que le module de Young mesuré selon la méthode de microindentation vaut 34 Gpa pour une couche de protection d'environ 4 µm.

### Exemple 2

### a. Protocole expérimental

L'échantillon est le même que celui repris à l'exemple 1, et la distance échantillon - injecteur reste inchangée. Le pré-traitement reste le même.

Puis, le débit d'azote est ramené à 0,14 Nl/min et on introduit de l'hélium dans la zone de décharge à un débit de 426 Ncm³/min puis le silane à un débit de 15 Ncm³/min. La pression de travail est de 2 hPa.

Après la phase de dépôt, un PFDA est effectué pendant 3 minutes à la pression de 1,3 hPa.

### b. Caractéristiques du film déposé

Les caractéristiques détectées en spectroscopie IR sont inchangées. La vitesse de dépôt est plus lente. Le film a un caractère brillant plus marqué. Aucune évaluation mécanique n'a pu être définie sur ce type de film étant donné sa trop faible épaisseur.

### Exemple 3

### a. Protocole expérimental

L'échantillon est le même que celui utilisé aux exemples 1 et 2, mais dans ce cas, on a prévu d'ajouter dans le dispositif un tube d'amenée du plasma froid différé d'azote directement dans le réacteur au-dessus de l'échantillon.

Les autres données expérimentales restent les mêmes.

### b. Caractéristiques du film déposé

On observe des caractéristiques fort peu différentes de celles décrites à l'exemple 1, bien que la vitesse de dépôt de la couche de protection soit nettement plus rapide.

**Tableau 1.**

| **Composés pouvant être utilisés pour réaliser la couche de protection** | **Formule** | **Micro-dureté Vickers en GPa** | **Module d'élasticité en GPa** |
|---|---|---|---|
| Oxyde de silicium | SiO₂ | 5-8 | - |
| Nitrure de silicium | Si₃N₄ | 8-17 | 250-330 |
| Nitrure de titane | TiN | 21 | 600 |
| Carbure de silicium | SiC | 26 | - |
| Carbure de titane | TiC | 28 | - |
| Carbure de bore | B₄C | 30 | - |
| Nitrure de bore cubique | c-BN | 45 | - |
| Nitrure de carbone | C₃N₄ | > | 900 |

**Tableau 2**

| **Composés donnés à titre de comparaison** | **Microdureté Vickers en GPa** | **Module d'élasticité en GPa** |
|---|---|---|
| PVC | 0,07 | 2 |
| Acier | 9 | 210 |

**Tableau 3.**

| **Exemple 1** | | | |
|---|---|---|---|
| **Durée de dépôt (h)** | 1 | 2 | 3 |
| **Epaisseur du film (µm)** | 1,5 | 6 | 10 |

| **Exemple 2** | | | |
|---|---|---|---|
| **Durée de dépôt (h)** | 1 | | |
| **Epaisseur du film (µm)** | 0,3 | | |

| **Exemple 3** | | | |
|---|---|---|---|
| **Durée de dépôt (h)** | 0,5 | 1 | 1,5 |
| **Epaisseur du film (µm)** | 2,5 | 4 | 6 |

## Revendications

1. Procédé d'obtention d'un revêtement de sol comprenant au moins un substrat polymérique résilient, c'est-à-dire déformable sous l'impact, et une couche de protection constituée d'au moins un nitrure inorganique amorphe, dans lequel le dépôt de ladite couche de protection sur ledit substrat polymérique résilient comprend les étapes suivantes :
- on place ledit substrat dans une enceinte,
- on forme un plasma froid différé à base d'azote que l'on injecte dans ladite enceinte,
- on injecte dans ladite enceinte un composé précurseur volatil, ledit plasma froid différé à base d'azote induisant alors une réaction de décomposition dudit composé précurseur volatil,
de façon à obtenir une couche de protection présentant une dureté Vickers supérieure à 1 GPa et un module d'élasticité (module de Young) inférieur à 80 GPa.

2. Procédé selon la revendication 1, **caractérisé en ce que** la couche de protection réalisée à partir du nitrure inorganique amorphe présente une dureté Vickers comprise entre 1 et 10 GPa et un module d'élasticité ne dépassant pas 50 Gpa.

3. Procédé selon la revendication 2, **caractérisée en ce que** la couche de protection réalisée à partir du nitrure inorganique amorphe présente un module d'élasticité compris entre 20 et 50 Gpa.

4. Procédé selon l'une quelconque des revendications précédentes, **caractérisé en ce que** le plasma froid différé à base d'azote est un plasma induit par décharge de type micro-ondes ou de type radiofréquence.

5. Procédé selon la revendication 4, **caractérisé en ce que** la fréquence utilisée pour créer le plasma est de 2450 MHz ou 13,56 MHz.

6. Procédé selon l'une quelconque des revendications précédentes, **caractérisé en ce que** le dépôt de la couche de protection sur ledit substrat est réalisé dans la zone de post-décharge du plasma froid différé.

7. Procédé selon la revendication 6, **caractérisé en ce que** la couche de protection déposée sur ledit substrat est réalisée dans le zone de post-décharge lointaine, c'est-à-dire dans la zone exempte d'espèces ioniques.

8. Procédé selon l'une quelconque des revendications précédentes, **caractérisé en ce que** le précurseur utilisé pour obtenir le nitrure inorganique amorphe est un dérivé du silicium.

9. Procédé selon la revendication 8, **caractérisé en ce que** le précurseur utilisé pour obtenir le nitrure inorganique amorphe est un dérivé de silicium choisi dans le groupe constitué par SiH4, SiCl₄, SiF₄, SiH₂Cl₂, Si₂H₆, Si3H₈, CH₃-CH₂-SiH₂Cl, CH₃-CH₂-SiHCl₂, N[(CH₃)₂]₃SiH, N[(CH₃)₂]₄Si.

10. Procédé selon l'une quelconque des revendications précédentes, **caractérisé en ce que** le précurseur est introduit dans la zone de post-décharge lointaine.

11. Procédé selon la revendication 10,
**caractérisé en ce que** le précurseur est introduit colinéairement au gaz plasmagène.

12. Procédé selon l'une quelconque des revendications précédentes, **caractérisé en ce que** l'on procède à un pré-traitement par plasma froid différé à base d'azote en vue d'augmenter l'énergie de surface des polymères constituant le substrat polymérique résilient du revêtement de sol et de favoriser leur aptitude à l'adhésion.

13. Procédé selon la revendication 12, **caractérisé en ce que** ce pré-traitement est effectué en zone de post-décharge lointaine.

14. Procédé selon l'une quelconque des revendications précédentes, **caractérisé en ce que** l'on effectue un post-traitement afin d'éliminer les traces résiduelles de précurseur.

15. Procédé selon la revendication 14, **caractérisé en ce que** le post-traitement est effectué à l'aide d'un plasma froid différé à base d'azote.

16. Procédé selon l'une quelconque des revendications précédentes, **caractérisé en ce que** les pressions de travail sont comprises entre 1 et 20 hPa et les températures sont proches de la température ambiante, à savoir une température ne dépassant pas 325°K.

17. Revêtement de sol comprenant au moins un substrat polymérique résilient, c'est-à-dire déformable sous l'impact, **caractérisé en ce que** ledit substrat est recouvert d'une couche de protection constituée d'au moins un nitrure inorganique amorphe, le recouvrement étant réalisé par le procédé de l'une des revendications précédentes et ladite couche de protection présentant une dureté Vickers supérieure à 1 GPa et un module d'élasticité (module de Young) inférieur à 80 GPa.

18. Revêtement selon la revendication 17, **caractérisé en ce que** la couche de protection réalisée à partir du nitrure inorganique amorphe présente une dureté Vickers comprise entre 1 et 10 GPa et un module d'élasticité ne dépassant pas 50 Gpa.

19. Revêtement selon la revendication 18, **caractérisé en ce que** la couche de protection réalisée à partir du nitrure inorganique amorphe présente un module d'élasticité compris entre 20 et 50 GPa.

20. Revêtement selon l'une quelconque des revendications 17 à 19, **caractérisé en ce que** l'épaisseur de la couche de protection est inférieure à 10 µm.

21. Revêtement selon la revendication 20, **caractérisé en ce que** l'épaisseur de la couche de protection est comprise entre 1 et 5 µm.

22. Revêtement selon l'une quelconque des revendications 17 à 21, **caractérisé en ce que** la couche de protection est à base d'un nitrure de silicium.

23. Revêtement selon l'une quelconque des revendications 17 à 22, **caractérisé en ce que** le substrat polymérique résilient du revêtement de sol est à base de PVC, de résine acrylique ou d'homo- ou copolymères d'oléfine.

## Patentansprüche

1. Verfahren zum Herstellen eines Bodenbelages , welcher mindestens ein elastisches polymeres, d.h. bei einem Stoß deformierbares Substrat und eine aus mindestens einem anorganischen amorphen Nidrid bestehende Schutzschicht aufweist, bei dem das Auftragen der besagten Schutzschicht auf das besagte elastische polymere Substrat folgende Schritte aufweist :
- das besagte Substrat wird in einer Einfassung angeordnet,
- es wird ein stickstoffbasiertes differiertes Kaltplasma erzeugt, das in die besagte Einfassung eingespritzt wird,
- in die besagte Einfassung wird eine flüchtige Vorläuferverbindung eingespritzt, wobei das stickstoffbasierte differierte Kaltplasma dann eine Zersetzungsreaktion der besagten flüchtigen Vorläuferverbindung hervorruft,
so dass die hervorgehende Schutzschicht eine Vickershärte über 1 Gpa und einen Elastizitätsmodul (Youngmodul) unter 80 Gpa aufweist.

2. Verfahren nach Anspruch 1, **dadurch gekennzeichnet, dass** die aus dem anorganischen amorphen Nitrid bestehende Schutzschicht eine Vickershärte zwischen 1 und 10 Gpa und einen Elastizitätsmodul aufweist, der nicht 50 Gpa überschreitet.

3. Verfahren nach Anspruch 2, **dadurch gekennzeichnet, dass** die aus einem anorganischen amorphen Nitrid bestehende Schutzschicht einen Elastizitätsmodul zwischen 20 und 50 Gpa aufweist.

4. Verfahren nach irgendeinem der vorangehenden Ansprüche, **dadurch gekennzeichnet, dass** das differierte Kaltplasma auf Stickstoffbasis ein Plasma ist, welches durch Mikrowellenentladung bzw. Radiofrequenzentladung induziert wird.

5. Verfahren nach Anspruch 4, **dadurch gekennzeichnet, dass** die zur Erzeugung des Plasmas benutzte Frequenz sich entweder auf 2450 Hz oder 13,56 Mhz beläuft.

6. Verfahren nach irgendeinem der vorangehenden Ansprüche, **dadurch gekennzeichnet, dass** das Auftragen der besagten Schutzschicht auf das besagte Substrat im Nachentladungsbereich des differierten Kaltplasmas ausgeführt wird.

7. Verfahren nach Anspruch 6, **dadurch gekennzeichnet, dass** die auf dem besagten Substrat aufgetragene Schutzschicht im entfernten Nachentladungsbereich, d.h. im Bereich, der frei von Ionenarten ist, ausgeführt wird.

8. Verfahren nach irgendeinem der vorangehenden Ansprüche, **dadurch gekennzeichnet, dass** der zur Erzeugung des amorphen anorganischen Nitrids benutzte Vorläufer ein Siliziumderivat ist.

9. Verfahren nach Anspruch 8, **dadurch gekennzeichnet, dass** der zur Erzeugung des amorphen anorganischen Nitrids benutzte Vorläufer ein Siliziumderivat ist, das aus der Gruppe SiH₄, SiCl₄, SiF₄, SiH₂Cl₂, Si₂H₆, Si₃H₈, CH₃-CH₂-SiH₂Cl, CH₃-CH₂-SiHCl₂, N [(CH₃)₂]₃SiH, N[(CH₃)₂]₄Si ausgewählt wird.

10. Verfahren nach irgendeinem der vorangehenden Ansprüche, **dadurch gekennzeichnet, dass** der Vorläufer in den entfernten Nachentladungsbereich eingeführt wird.

11. Verfahren nach Anspruch 10, **dadurch gekennzeichnet, dass** der Vorläufer kolinear in das Plasmagas eingeführt wird.

12. Verfahren nach irgendeinem der vorangehenden Ansprüche, **dadurch gekennzeichnet, dass** eine Vorbearbeitung durch stickstoffbasiertes differiertes Kaltplasma vorgenommen wird, um die Oberflächenenergie der das polymere elastische Substrat des Bodenbelags aufbauenden Polymere zu erhöhen und ihre Adhäsionsfähigkeit zu begünstigen.

13. Verfahren nach Anspruch 12, **dadurch gekennzeichnet, dass** diese Vorbearbeitung im entfernten Nachentladungsbereich ausgeführt wird.

14. Verfahren nach irgendeinem der vorangehenden Ansprüche, **dadurch gekennzeichnet, dass** eine Nachbearbeitung durchgeführt wird, um Restspuren des Vorläufers zu entfernen.

15. Verfahren nach Anspruch 14, **dadurch gekennzeichnet, dass** die Nachbearbeitung mit Hilfe eines differierten Kaltplasmas auf Stickstoffbasis durchgeführt wird.

16. Verfahren nach irgendeinem der vorangehenden Ansprüche, **dadurch gekennzeichnet, dass** die Arbeitsdrücke zwischen 1 und 20 hPa und die Temperaturen nahe der Umgebungstemperatur, d.h. eine Temperatur, die nicht 325°K übersteigt, liegen.

17. Bodenbelag, welcher mindestens ein elastisches polymeres d.h. bei einem Stoß deformierbares Substrat aufweist, **dadurch gekennzeichnet, dass** das besagte Substrat mindestens durch eine aus anorganischem amorphem Nidrid bestehende Schutzschicht beschichtet ist , wobei die Beschichtung durch das Verfahren einer der vorhergehenden Ansprüche ausgefährt wird und die besagte Schutzschicht eine Vickershärte über 1 Gpa und einen Elastizitätsmodul (Youngmodul) unter 80 Gpa aufweist.

18. Bodenbelag nach Anspruch 17, **dadurch gekennzeichnet, dass** die aus einem anorganischen amorphen Nitrid bestehende Schutzschicht eine Vickershärte zwischen 1 und 10 Gpa und einen Elastizitätsmodul (Youngmodul) aufweist, der nicht 50 Gpa übersteigt.

19. Bodenbelag nach Anspruch 18, **dadurch gekennzeichnet, dass** die aus einem anorganischen amorphen Nitrid bestehende Schutzschicht einen Elastizitätsmodul zwischen 20 und 50 Gpa aufweist.

20. Bodenbelag nach irgendeinem der Ansprüche 17 bis 19, **dadurch gekennzeichnet, dass** die Dicke der Schutzschicht unter 10 µm ist.

21. Bodenbelag nach Anspruch 20, **dadurch gekennzeichnet, dass** die Dicke der Schutzschicht zwischen 1 und 5 µm liegt.

22. Bodenbelag nach irgendeinem der Ansprüche 17 bis 21, **dadurch gekennzeichnet, dass** die Schutzschicht aus Siliziumnitrid besteht.

23. Bodenbelag nach irgendeinem der Ansprüche 17 bis 22, **dadurch gekennzeichnet, dass** das elastische polymere Substrat des Bodenbelags aus PVC, Acrylharz oder Olefin-Homopolymer oder Olefin-Copolymer besteht.

## Claims

1. Process for obtaining a floor covering comprising at least one resilient polymeric component, i.e. deformable under impact, and one protective layer consisting of at least one amorphous inorganic nitride, in which the deposit of said protective layer on said resilient polymeric substrate comprises the steps of:
- placing said substrate in a chamber;
- forming a nitrogen-based remote cold plasma and injecting it in said chamber;
- injecting in said chamber a volatile precursor compound, said nitrogen-based remote cold plasma then induces a decomposition reaction of said volatile precursor compound,
so as to obtain a protective layer having a Vickers hardness of more than 1 GPa and a modulus of elasticity (Young's modulus) of less than 80 GPa.

2. Process according to Claim 1, **characterised in that** the protective layer produced from amorphous inorganic nitride has a Vickers hardness of between 1 and 10 GPa and a modulus of elasticity not exceeding 50 GPa.

3. Process according to Claim 2, **characterised in that** the protective layer produced from amorphous inorganic nitride has a modulus of elasticity of between 20 and 50 GPa.

4. Process according to any one of the preceding claims, **characterised in that** the nitrogen-based remote cold plasma is a plasma induced by microwave or radio frequency discharge.

5. Process according to Claim 4, **characterised in that** the frequency used to produce the plasma is of 2450 MHz or 13,56 MHz.

6. Process according to any one of the preceding claims, **characterised in that** the deposition of the protective layer on said substrate is achieved in the post-discharge area of the remote cold plasma.

7. Process according to Claim 6, **characterised in that** the protective layer deposited on said substrate is achieved in the far post-discharge area, i.e. in the area free of ionic species.

8. Process according to any one of the preceding claims, **characterised in that** the precursor used to obtain the amorphous inorganic nitride is a silicon derivative.

9. Process according to Claim 8, **characterised in that** the precursor used to obtain the amorphous inorganic nitride is a silicon derivative chosen among the group consisting of SiH₄, SiCl₄, SiF₄, SiH₂Cl₂, Si₂H₆, Si₃H₈, CH₃-CH₂-SiH₂Cl, CH₃-CH₂-SiHCl₂, N[(CH₃)₂]₃SiH, N[(CH₃)₂]₄Si.

10. Process according to any one of the preceding claims, **characterised in that** the precursor is introduced in the far post-discharge area.

11. Process according to Claim 10, **characterised in that** the precursor is introduced colinearly to the plasma-generating gas.

12. Process according to one any of the preceding claims, **characterised in that** a pre-treatment by nitrogen-based remote cold plasma occurs in order to increase the surface energy of the polymers constituting the resilient polymeric substrate of the floor covering and to improve their adhesion ability.

13. Process according to Claim 12, **characterised in that** this pre-treatment occurs in the far post-discharge area.

14. Process according to any one of the preceding claims, **characterised in that** a post-treatment occurs in order to eliminate residual traces of the precursor.

15. Process according to Claim 14, **characterised in that** the post-treatment occurs with nitrogen-based remote cold plasma.

16. Process according to any one of the preceding claims, **characterised in that** the working pressures are between 1 and 20 hPa and the temperatures are close to room temperature, i.e. a temperature not exceeding 325°K.

17. Floor covering comprising at least one resilient polymeric substrate, i.e. deformable under impact, **characterised in that** said substrate is coated with a protective layer consisting of at least one amorphous inorganic nitride, the covering being produced by the process according to one of the preceding claims and said protective layer having a Vickers hardness of more than 1 GPa and a modulus of elasticity (Young's modulus) of less than 80 GPa.

18. Covering according to Claim 17, **characterised in that** the protective layer obtained from amorphous inorganic nitride has a Vickers hardness of between 1 and 10 GPa and a modulus of elasticity not exceeding 50 GPa.

19. Covering according to Claim 18, **characterised in that** the protective layer obtained from amorphous inorganic nitride has a modulus of elasticity of between 20 and 50 GPa.

20. Covering according to any one of the claims 17 to 19, **characterised in that** the thickness of the protective layer is less than 10 µm.

21. Covering according to Claim 20, **characterised in that** the thickness of the protective layer is between 1 and 5 µm.

22. Covering according to any one of the claims 17 to 21, **characterised in that** the protective layer is based on silicon nitride.

23. Covering according to any one of the claims 17 to 22, **characterised in that** the resilient polymeric substrate of the floor covering is based on PVC, acrylic resin or olefin homopolymers or copolymers.
